Europäisches Patentamt

European Patent Office

Office européen des brevets

(11) Veröffentlichungsnummer: **0 135 606**
**B1**

(12) **EUROPÄISCHE PATENTSCHRIFT**

(45) Veröffentlichungstag der Patentschrift:
24.06.87

(51) Int. Cl.⁴: **H 03 H 17/04**

(21) Anmeldenummer: **83109680.5**

(22) Anmeldetag: **28.09.83**

(54) **Zustandsvariablenfilter.**

(43) Veröffentlichungstag der Anmeldung:
**03.04.85 Patentblatt 85/14**

(45) Bekanntmachung des Hinweises auf die Patenterteilung:
**24.06.87 Patentblatt 87/26**

(84) Benannte Vertragsstaaten:
**AT CH DE FR GB LI**

(56) Entgegenhaltungen:
**IEEE TRANSACTIONS ON ACOUSTICS SPEECH AND SIGNAL PROCESSING, Band ASSP-30, Nr. 6, Dezember 1982, Seiten 963-973, New York, US W.E. HIGGINS et al.: "Noise reduction strategies for digital filters: error spectrum shaping versus the optimal linear state-space formulation"**

(73) Patentinhaber: **ANT Nachrichtentechnik GmbH, Gerberstrasse 33, D-7150 Backnang (DE)**

(72) Erfinder: **Göckler, Heinz, Dipl.-Ing., Elbinger Strasse 52, D-7150 Backnang (DE)**

(74) Vertreter: **Schickle, Gerhard, Dipl.-Ing., ANT Nachrichtentechnik GmbH Patent- und Lizenzabteilung Gerberstrasse 33, D-7150 Backnang (DE)**

## Beschreibung

Die Erfindung bezieht sich auf eine Schaltungsanordnung zur digitalen Filterung eines Eingangssignals gemäss Oberbegriff der Patentansprüche 1 oder 2 (Zustandsvariablenfilter N. Ordnung).

Zustandsvariablenfilter zweiter Ordnung sind beschrieben in dem Aufsatz von Jackson «Optimal Synthesis of Second-Order State-Space Structures for Digital Filters» in IEEE Transactions on Circuits and Systems, Vol. CAS-26, Nr. 3, März 1979, Seiten 149 bis 153, sowie Zustandsvariablenfilter erster und zweiter Ordnung in dem Aufsatz von Barnes «Roundoff Noise and Overflow in Normal Digital Filters» in IEEE Transactions on Circuits and Systems, Vol. CAS-26, Nr. 3, März 1979, Seiten 154 bis 159.

Solche Filter werden vornehmlich für schmalbandige Anwendungen realisiert, sie weisen ein geringes Eigenrauschen auf und sind Antwort- und Überlaufstabil. Bei schmalbandigen Filtern rücken die Pole nahe an $z = \pm 1$ in der Ebene der komplexen Frequenz. Das bedeutet, dass bei einem Zustandsvariablenfilter zweiter Ordnung die Komponenten b1 und b2 eines ersten bewertenden Vektors $\underline{b}$ sowie die Diagonal-Elemente a12 und a21 der Zustandsübergangsmatrix $\underline{A}$ sehr kleine Werte gegenüber 1 annehmen und dass die rückkoppelnden Elemente a11 und a22 der Zustandsübergangsmatrix $\underline{A}$ nahezu den Wert 1 annehmen. Das bedeutet aber, dass bei Festkommaarithmetik eine grosse Koeffizienten-Wortlänge bei der digitalen Realisierung erforderlich ist.

Aufgabe der vorliegenden Erfindung war es deshalb, eine Schaltungsanordnung für eine Realisierung vorgenannter Zustandsvariablenfilter anzugeben, die es erlaubt, die Koeffizienten-Wortlänge bei Festkommaarithmetik bei gleichbleibender Frequenzganggenauigkeit zu vermindern oder eine Verbesserung der Frequenzganggenauigkeit bei gleichbleibender Koeffizienten-Wortlänge zu erreichen.

Die Lösung erfolgt mit den kennzeichnenden Merkmalen der beiden Hauptansprüche.

Die Zustandsvariablenstruktur gemäss vorliegender Erfindung weist die Vorteile auf, dass die Koeffizienten-Wortlänge bei Festkommaarithmetik bei vorgegebener Frequenzganggenauigkeit vermindert wird und/oder, dass die Frequenzganggenauigkeit bei vorgegebener Koeffizienten-Wortlänge verbessert wird. Eine Verminderung der Koeffizienten-Wortlänge führt zu einer Hardware-Realisierung mit kleinerer Speicherplatzaufwendung.

Durch die Unteransprüche ergeben sich optimale Ausgestaltungen der Erfindung.

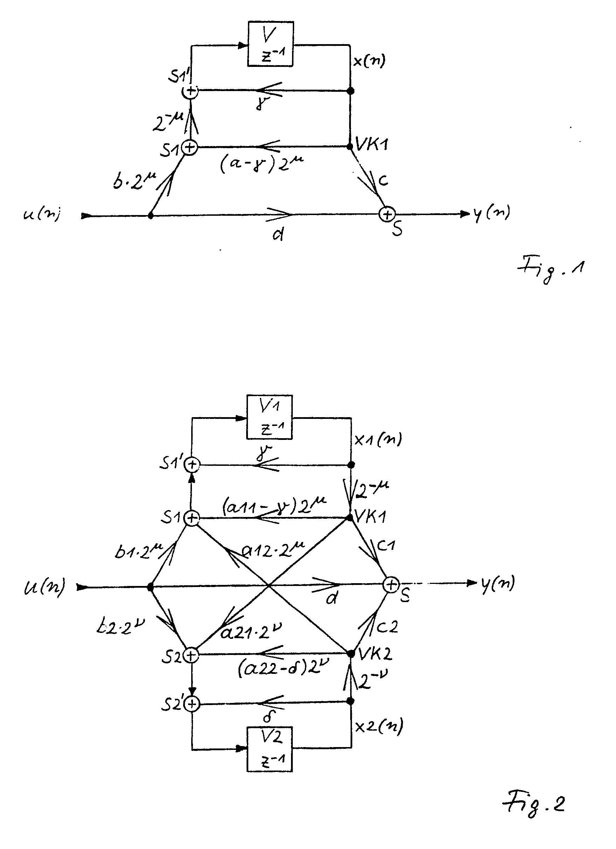

Es folgt nun die Beschreibung der Erfindung anhand der Figuren. Die Fig. 1 und 2 zeigen ein Zustandsvariablenfilter erster bzw. zweiter Ordnung, bei denen mittels Bewertungsänderungen gemäss der Unteransprüche 5 bzw. 6 vorgegangen wurde.

In Fig. 1 ist ein Zustandsvariablenfilter erster Ordnung mit dem Eingangssignal u(n), mit dem Ausgangssignal y(n), mit einem ersten Summierer S1, mit einem Endsummierer S, durch den das mit d bewertete Eingangssignal und das mit c bewertete Zustandssignal x(n) des Verzögerungsgliedes zum Ausgangssignal zusammengefasst werden, sowie mit einem Verteilerknoten VK1 erkennbar. Erfindungsgemäss wird der erste bewertende Vektor $\underline{b}$, der wie eingangs erwähnt, sehr klein gegen 1 ist, um $\mu$ Schritte nach links geschiftet, d.h. um den Faktor $\alpha = 2^\mu$ vergrössert. Entsprechend muss das zweite Eingangssignal des Summierers S1 ebenfalls um $2^\mu$ verstärkt werden. Zur Kompensation wird das Ausgangssignal des Summierers S1 um $2^{-\mu}$ wieder verkleinert. Da das Zustandsübergangselement a, wie eingangs erwähnt, nahe 1 ist, wird von a ein Wert $\gamma$ abgezogen derart, dass durch die anschliessende Schiftung um $\mu$ Schritte nach links, wodurch die signifikanten Bits wie bei der Schiftung des Koeffizienten b jeweils zu höherwertigen Stellen geschoben werden, eine Verkürzung der Festkomma-Wortlänge erreicht wird. Das Zustandssignal des Verzögerungsgliedes V wird also mit $(a-\gamma) \cdot 2^\mu$ bewertet und über den Summierer S1 dem Eingang desselben wieder zurückgeführt. Als Ausgleichsmassnahme wird das Zustandssignal x(n) des Verzögerungsgliedes V zusätzlich mit $\gamma$ bewertet und über einen weiteren Summierer S1' direkt auf den Eingang des Verzögerungsgliedes zurückgekoppelt. Durch geeignete Wahl des Wertes $\gamma$ kann erreicht werden, dass b und a-$\gamma$ Werte der gleichen Grössenordnung erreichen, d.h. jeweils die gleiche Anzahl führender Nullen der Binärdarstellung aufweisen.

Die Fig. 2 zeigt ein Zustandsvariablenfilter zweiter Ordnung, das im Prinzip die verdoppelte, symmetrische Darstellung der Struktur nach Fig. 1 darstellt, wobei die Diagonal-Elemente a12 und a21 der Zustandsübergangsmatrix $\underline{A}$ hinzukommen. Da diese Diagonal-Elemente ebenfalls kleine Werte aufweisen, werden sie in gleicher Weise wie die beiden Komponenten b1 und b2 des ersten bewertenden Vektors $\underline{b}$ um $\mu$ bzw. $\nu$ Schritte nach links geschiftet, wodurch sich die bei der Beschreibung der Fig. 1 geschilderte Wirkung ergibt. Der einzige Unterschied zwischen den beiden Figuren besteht darin, dass die Kompensationsmassnahme des Rechtsschiftens also die Verkleinerung um $\alpha = 2^{-\mu}$ bzw. $\alpha = 2^{-\nu}$, nicht direkt am Ausgang der ersten Summierer S1 bzw. S2 erfolgt, sondern beim Zustandssignal x1(n) bzw. x2(n) der beiden Verzögerungsglieder V1 und V2, also am Eingang des Verteilerknotens VK1 bzw. VK2. Dadurch ist die Einsparung der beiden weiteren Summierer S1' bzw. S2' möglich, wenn die genannten Ausgangssignale mit $\gamma$ bzw. $\delta$ bewertet, direkt in die beiden ersten Summierer S1 bzw. S2 geführt werden.

Eine weitere Verminderung des Filtereigenrauschens ergibt sich, wenn die Wortlänge der Verzögerungsglieder V1 und V2 jeweils um $\mu$ bzw. $\nu$ Überlaufbits vergrössert wird.

Die Strukturen nach Fig. 1 bzw. Fig. 2 machen einen weiteren Multiplizierer für $\gamma$ bzw. $\gamma$ und $\delta$ erforderlich.

Dies kann verhindert werden durch eine geeignete Wahl von $\gamma$ und $\delta$. Erstens kann $\gamma = \delta = 1$ gewählt werden, so dass der Multiplizierer für die Bewertung mit $\gamma$ bzw. $\delta$ entfallen kann. Zweitens kann $\gamma$ und $\delta$ so bemessen werden, dass $\gamma = a11 \pm 2^{-\mu}$ und entsprechend $\delta = a22 \pm 2^{-\nu}$ bemessen wird, wodurch $(a11 - \gamma) \cdot 2^\mu = \pm 1$ und $(a22 - \delta) 2^\nu = \pm 1$ werden, wodurch die entsprechende Bewertung mittels eines Multiplizierers entfallen kann für eine direkte Durchreichung des Signals oder erforderlichenfalls unter Zwischenschaltung eines Inverters, welcher jedoch weniger aufwendig ist als ein Multiplizierer.

Es wurde aufgezeigt, dass mit Hilfe der erfindungsgemässen Zustandsvariablenstruktur eine Verminderung der Festkomma-Koeffizienten-Wortlänge bei vorgegebener Frequenzganggenauigkeit und/oder eine Verbesserung der Frequenzganggenauigkeit bei vorgegebener Koeffizienten-Wortlänge erreicht wird, wodurch insgesamt ein geringerer Hardware-Realisierungsaufwand notwendig ist.

**Patentansprüche**

1. Schaltungsanordnung zur digitalen Filterung eines Eingangssignals u(n), das durch die N Komponenten eines ersten Vektors $\underline{b}$ bewertet, auf die Eingänge von N (N grösser gleich 1) Verzögerungsgliedern (V, V1 ...) eingekoppelt wird, wobei die Zustandssignale x(n), x1(n) ... dieser Verzögerungsglieder mit den einzelnen Elementen einer Zustandsübergangsmatrix $\underline{A}$ bewertet und über erste Summierer (S1) auf die Eingänge der Verzögerungsglieder zurückgeführt werden und wobei die Zustandssignale x(n), x1(n) ... der Verzögerungsglieder mit den N Komponenten eines zweiten Vektors $\underline{c}$ bewertet und zusammen mit dem mit dem Skalar d bewerteten Eingangssignal über einen weiteren Summierer (S) zum Ausgangssignal y(n) aufsummiert werden (Zustandsvariablenfilter N. Ordnung), dadurch gekennzeichnet, dass die Bewertung eines Summierer-Ausgangs-Signals um den Faktor $\alpha$ verändert wird und dass alle Eingangssignale dieses Summierers (S1) oder der ihm voranngehenden Signalpfadabschnitte mit der entgegengesetzten Änderung $1/\alpha$ bewertet werden derart, dass entlang aller möglichen Signalpfade zwischen Eingang und Ausgang des Zustandsvariablenfilters jeweils die Anzahl der Änderungen gleich der Anzahl der entgegengesetzten Änderungen ist.

2. Schaltungsanordnung zur digitalen Filterung eines Eingangssignals u(n), das durch die N Komponenten eines ersten Vektors $\underline{b}$ bewertet, auf die Eingänge von N (N grösser gleich 1) Verzögerungsgliedern (V, V1 ...) eingekoppelt wird, wobei die Zustandssignale x(n), x1(n) ... dieser Verzögerungsglieder mit den einzelnen Elementen einer Zustandsübergangsmatrix $\underline{A}$ bewertet und über erste Summierer (S1) auf die Eingänge der Verzögerungsglieder zurückgeführt werden und wobei die Zustandssignale x(n), x1(n) ... der Verzögerungsglieder mit den N Komponenten eines zweiten Vektors $\underline{c}$ bewertet und zusammen mit dem Skalar d bewerteten Eingangssignal über einen weiteren Summierer (s) zum Ausgangssignal y(n) aufsummiert werden (Zustandsvariablenfilter N. Ordnung), dadurch gekennzeichnet, dass die Bewertung eines Verteilerknoten-Eingangs-Signals um den Faktor $\alpha$ verändert wird und dass alle Ausgangssignale dieses Verteilerknotens oder der ihm nachfolgenden Signalpfadabschnitte mit der entgegengesetzten Änderung $1/\alpha$ bewertet werden derart, dass entlang aller möglichen Signalpfade zwischen Eingang und Ausgang des Zustandsvariablenfilters jeweils die Anzahl der Änderungen gleich der Anzahl der entgegengesetzten Änderungen ist.

3. Schaltungsanordnung nach Anspruch 1 und/oder 2, dadurch gekennzeichnet, dass die Bewertungsänderung durch Multiplikation mit dem Faktor $\alpha$ bzw. $1/\alpha$ erfolgt.

4. Schaltungsanordnung nach Anspruch 3, dadurch gekennzeichnet, dass die Bewertungsänderung durch Verschiebung des Bewertungsfaktors um $\mu$ Schritte erfolgt, wobei $\alpha = 2^{\pm\mu}$ ist.

5. Schaltungsanordnung nach Anspruch 1 und/oder 2, dadurch gekennzeichnet, dass die Bewertungsänderung eines mit einem Bewertungsfaktor w bewerteten Signals durch Addition eines Skalars $\pm \beta$ zum Bewertungsfaktor w erfolgt und dass die entgegengesetzte Änderung durch Addition des mit w $\pm \beta$ bewerteten und des mit $\mp \beta$ bewerteten Signals erfolgt.

6. Schaltungsanordnung nach Anspruch 4 und 5 mit N = 1 (Zustandsvariablenfilter erster Ordnung), dadurch gekennzeichnet, dass die Bewertung mit dem ersten Vektor $\underline{b}$ durch Verschiebung um $\mu$ Schritte nach links um $\alpha = 2^\mu$ vergrössert wird, dass die Bewertung durch das Zustandsübergangselement a durch Subtraktion eines Skalars $\gamma$ verkleinert und durch Verschiebung um ebenfalls $\mu$ Schritte nach links um $\alpha = 2^\mu$ wiederum vergrössert wird, dass das Zustandssignal x(n) des Verzögerungsgliedes (V) oder das Ausgangssignal des ersten Summierers (S1) durch Verschiebung um $\mu$ Schritte nach rechts $2^{-\mu}$ bewertet wird (die vorangegangenen Vergrösserungen egalisierende Verkleinerung) und dass das Zustandssignal x(n) des Verzögerungsgliedes (V) mit $\gamma$ bewertet zusätzlich auf seinen Eingang zurückgeführt wird (Fig.1).

7. Schaltungsanordnung nach Anspruch 4 und 5 mit N = 2 (Zustandsvariablenfilter zweiter Ordnung), dadurch gekennzeichnet, dass die Bewertungen mit den beiden Komponenten b1 und b2 des ersten Vektors $\underline{b}$ durch Verschiebung um $\mu$ Schritte bzw. v Schritte nach links um $\alpha = 2^\mu$ bzw. um $\alpha = 2^v$ vergrössert werden, dass die Bewertungen mit den beiden Diagonalelementen a12 und a21 der Zustandsübergangsmatrix $\underline{A}$ durch dieselbe Operation ebenfalls um $\alpha = 2^\mu$ bzw. $\alpha = 2^v$ vergrössert werden, dass die Bewertungen mit den Eigenelementen a11, a22 der Zustandsübergangsmatrix $\underline{A}$ durch Subtraktion eines Skalars $\gamma$ bzw. $\delta$ verkleinert werden und anschliessend durch Verschiebung um ebenfalls $\mu$ bzw. v Schritte nach links um $\alpha = 2^\mu$ bzw. um $\alpha = 2^v$ vergrössert werden, dass das Zustandssignal x1(n) des Verzögerungsgliedes (V1) oder das Ausgangssignal des ersten Summierers (S1) durch Verschiebung um $\mu$ Schritte nach rechts mit $1/\alpha = 2^{-\mu}$ bewertet und das Ausgangssignal des zweiten Verzögerungsgliedes (V2) oder das Ausgangssignal des anderen ersten Summierers (S2) ebenfalls durch Verschiebung nach rechts um v Schritte mit $1/\alpha = 2^{-v}$ bewertet wird (die vorangegangenen Vergrösserungen egalisierende Verkleinerung) und dass die Zustandssignale x1(n) und x2(n) der Verzögerungsglieder (V1, V2) mit $\gamma$ bzw. $\delta$ bewertet zusätzlich jeweils auf ihren Eingang zurückgeführt werden (Fig.2).

8. Schaltungsanordnung nach einem der vorhergehenden Ansprüche, dadurch gekennzeichnet, dass durch die Bewertungsänderungen sich die Bewertungen jeweils nur in dem durch die Wortlänge des zu realisierenden Zustandsvariablenfilters vorgegebenen Wertebereich bewegen.

### Claims

1. Circuit arrangement for digitally filtering an input signal u(n) which is weighted by the N components of a first vector $\underline{b}$ and coupled to the inputs of N (N $\geq$ 1) delay members (V, V1, ...), with the state signals x(n), x1(n), ... of these delay members being weighted with the individual elements of a state transfer matrix $\underline{A}$ and returned, via first summing members (S1), to the inputs of the delay members and the state signals x(n), x1(n), ... of the delay members are weighted with the N components of a second vector $\underline{c}$ and are summed, together with the input signal weighted with scalar d, in a further summing member (S) to form the output signal y(n) (variable state filter of the $N^{th}$ order), characterized in that the weighting of one summing member output signal is changed by the factor $\alpha$; and all input signals of this summing member (S1) or the signal path sections preceding it are weighted with the inverse change $1/\alpha$ in such a manner that, along all possible signal paths between input and output of the variable state filter, the number of changes is always equal the number of inverse changes.

2. Circuit arrangement for digitally filtering an input signal u(n) which is weighted by the N components of a first vector $\underline{b}$ and coupled to the inputs of N (N $\geq$ 1) delay members (V, V1, ...), with the state signals x(n), x1(n), ... of these delay members being weighted with the individual elements of a state transfer matrix $\underline{A}$ and being returned, via first summing members (S1), to the inputs of the delay member, with the state signals x(n), x1(n), ... of the delay members being weighted with the N components of a second vector $\underline{c}$ and being summed, together with the scalar d weighted input signal and via a further summing member (S), to form the output signal y(n) (variable state filter of the $N^{th}$ order), characterized in that the weighting of a distribution node input signal is varied by the factor $\alpha$ and all output signals of this distribution node or the signal path sections following it are weighted with the inverse change $1/\alpha$ in such a manner that, along all possible signal paths between input and output of the variable state filter, the number of changes is equal to the number of inverse changes.

3. Circuit arrangement according to claim 1 and/or claim 2, characterized in that the changes in weighting are effected by multiplication with the factor $\alpha$ or $1/\alpha$, respectively.

4. Circuit arrangement according to claim 3, characterized in that the change in weighting is effected by shifting the weighting factor by $\mu$ steps, where $\alpha = 2^{\pm\mu}$.

5. Circuit arrangement according to claim 1 and/or claim 2, characterized in that the change in weighting of a signal weighted with a weighting factor w is effected by adding a scalar $\pm\beta$ to the weight-ing factor w and the inverse change is effected by adding together the signal weighted with w $\pm$ $\beta$ and the signal weighted with $\mp$ $\beta$.

6. Circuit arrangement according to claims 4 and 5 where N = 1 (variable state filter of the first order), characterized in that the weighting with the first vector $\underline{b}$ is increased by $\alpha = 2^{\mu}$ by shifting $\mu$ steps to the left; the weighting by the state transfer element a is reduced by substracting a scalar $\gamma$ and is increased again by $\alpha = 2^{\mu}$ by likewise shifting $\mu$ steps to the left; the state signal x(n) of the delay member (V) or the output signal of the first summing member (S1) is weighted with $2^{-\mu}$ by shifting $\mu$ steps to the right (a reduction which equalizes the preceding increases); and the state signal x(n) of the delay member (V), weighted with $\gamma$, is additionally returned to its input (Figure 1).

7. Circuit arrangement according to claims 4 and 5 where N = 2 (variable state filter of the second order), characterized in that the weightings with the two components b1 and b2 of the first vector $\underline{b}$ are increased by $\alpha = 2^{\mu}$ and $\alpha = 2^{\nu}$, respectively, by shifting $\mu$ steps and $\nu$ steps to the left, respectively; the weightings with the two diagonal elements a12 and a21 of the state transfer matrix $\underline{A}$ are also increased by $\alpha = 2^{\mu}$ and $\alpha = 2^{\nu}$, respectively; the weightings with the own elements a11, a22 of the state transfer matrix $\underline{A}$ are reduced by substracting a scalar $\gamma$ or $\delta$, respectively, and are then increased by $\alpha = 2^{\mu}$ and $\alpha = 2^{\nu}$, respectively, by shifting $\mu$ steps and $\nu$ steps to the left, respectively, the state signal x1(n) of the delay member (V1) or the output signal of the first summing member (S1) is weighted with $1/\alpha = 2^{-\mu}$ by shifting $\mu$ steps to the right and the output signal of the second delay member (V2) or the output signal of the other first summing member (S2) is weighted by $1/\alpha = 2^{-\nu}$ likewise by shifting to the right by $\nu$ steps (reduction which equalizes the preceding increases); and the state signals x1(n) and x2(n) of the delay members (V1, V2) are weighted with $\gamma$ and $\delta$, respectively, and additionally each is returned to its input (Figure 2).

8. Circuit arrangement according to one of the preceding claims, characterized in that the changes in weighting cause the weightings to move only within the range of values given by the word length of the variable state filter that is to be realized.

### Revendications

1. Montage de filtrage numérique d'un signal d'entrée u(n) qui est pondéré par les N composantes d'un premier vecteur $\underline{b}$, puis couplé aux entrées de N (N $\geq$ 1) éléments de retard (V, V1, ...), les signaux d'état x(n), x1(n), ... de ces éléments de retard étant pondérés par les divers éléments d'une matrice de transition d'état $\underline{A}$ puis ramenés par des premiers additionneurs (S1) sur les entrées des éléments de retard, et les signaux d'état x(n), x1(n), ... des éléments de retard étant pondérés par les N composantes d'un second vecteur $\underline{c}$ puis additionnés avec le signal d'entrée pondéré par le scalaire d par un second additionneur (S) délivrant le signal de sortie y(n) (filtre à variables d'état d'ordre N), ledit montage étant caractérisé en ce que la pondération d'un signal de sortie d'additionneur est modifiée par le facteur α; et tous les signaux d'entrée dudit additionneur (S1) ou des sections précédentes du circuit sont pondérés par la variation opposée 1/α de façon que le nombre de variations soit égal au nombre de variations opposées le long de tous les circuits possibles entre l'entrée et la sortie du filtre à variables d'état.

2. Montage de filtrage numérique d'un signal d'entrée u(n), pondéré par les N composantes d'un premier vecteur $\underline{b}$ et couplé aux entrées de N (N ≥ 1) éléments de retard (V, V1, ...), les signaux d'état x(n), x1(n), ... de ces éléments de retard étant pondérés par les divers éléments d'une matrice de transition d'état $\underline{A}$ puis ramenés par des premiers additionneurs (S1) aux entrées des éléments de retard, et les signaux d'état x(n), x1(n), ... des éléments de retard étant pondérés par les N composantes d'un second vecteur $\underline{c}$ puis additionnés avec le signal d'entrée pondéré par le scalaire d par un second additionneur (S) délivrant le signal de sortie y(n) (filtre à variables d'état d'ordre N), ledit montage étant caractérisé en ce que la pondération d'un signal d'entrée de noeud répartiteur varie du facteur α; et tous les signaux d'entrée de ce noeud répartiteur ou des sections suivantes de circuit sont pondérés par la variation opposée 1/α de façon que le nombre de variations soit égal au nombre de variations opposées le long de tous les circuits possibles de signal entre l'entrée et la sortie du filtre à variables d'état.

3. Montage selon une des revendications 1 ou 2, caractérisé en ce que la variation de pondération est produite par multiplication par le facteur α ou 1/α.

4. Montage selon revendication 3, caractérisé en ce que la variation de pondération s'effectue par décalage du facteur de pondération de μ pas, avec α = $2^{\pm\mu}$.

5. Montage selon une des revendications 1 ou 2, caractérisé en ce que la variation de pondération d'un signal pondéré par un facteur w s'effectue par addition d'un scalaire ±β au facteur de pondération w; et la variation opposée s'effectue par addition du signal pondéré par w ± β et du signal pondéré par ∓ β.

6. Montage selon revendications 4 et 5 avec N = 1 (filtre à variables d'état d'ordre 1), caractérisé en ce que la pondération par le premier vecteur $\underline{b}$ est augmentée de α = $2^\mu$ par décalage de μ pas vers la gauche; la pondération par l'élément de transition d'état a est diminuée par soustraction d'un scalaire γ, puis augmentée de nouveau de α = $2^\mu$ par décalage de μ pas vers la gauche; le signal d'état x(n) de l'élément de retard (V) ou le signal de sortie du premier additionneur (S1) est pondéré de $2^{-\mu}$ par décalage de μ pas vers le droite (diminution compensant les augmentations précédentes); et le signal d'état x(n) de l'élément de retard (V) est en outre ramené à son entrée avec pondération par γ (figure 1).

7. Montage selon revendications 4 et 5 avec N = 2 (filtre à variables d'état d'ordre 2), caractérisé en ce que les pondérations par les deux composantes b1 et b2 du premier vecteur $\underline{b}$ sont augmentées de α = $2^\mu$ ou α = $2^\nu$ par décalage de μ ou ν pas vers la gauche; les pondérations par les deux éléments de diagonale a12 et a21 de la matrice de transition d'état $\underline{A}$ sont également augmentées de α = $2^\mu$ ou α = $2^\nu$ par la même opération; les pondérations par les éléments propres a11, a22 de la matrice de transition d'état $\underline{A}$ sont diminuées par soustraction d'un scalaire γ ou δ, puis augmentées de α = $2^\mu$ ou α = $2^\nu$ par décalage de μ ou ν pas vers la gauche; le signal d'état x1(n) de l'élément de retard (V1) ou le signal de sortie du premier additionneur (S1) est pondéré par 1/α = $2^{-\mu}$ par décalage de μ pas vers la droite et le signal de sortie du second élément de retard (V2) ou le signal de sortie de l'autre premier additionneur (S2) est pondéré par 1/α = $2^{-\nu}$ également par décalage de ν pas vers la droite (diminution compensant les augmentations précédentes); et les signaux d'état x1(n) et x2(n) des éléments de retard (V1, V2) sont en outre ramenés chacun sur son entrée avec pondération par γ ou δ (figure 2).

8. Montage selon une quelconque des revendications 1 à 7, caractérisé en ce que par suite de leurs variations, les pondérations se situent toujours uniquement sur la plage de valeurs prédéterminée par la longueur de mot du filtre à variables d'état à réaliser.

Fig. 1

Fig. 2